# EUROPÄISCHE PATENTSCHRIFT

(11) **EP 1 128 552 B1**
(45) Veröffentlichungstag und Bekanntmachung des Hinweises auf die Patenterteilung: **25.07.2007**
(21) Anmeldenummer: 00103653.2
(22) Anmeldetag: 21.02.2000
(51) Int. Cl.: H03H 7/12, H03J 3/08

(54) **Schaltungsanordnung zur Filterung eines Hochfrequenzsignals**
Circuit device for filtering a radio frequency signal
Circuit pour le filtrage d'un signal à haute fréquence

(43) Veröffentlichungstag der Anmeldung: 29.08.2001
(73) Patentinhaber: Infineon Technologies AG, 81669 München (DE)
(72) Erfinder: Krug, Erwin, 81927 München (DE)
(74) Vertreter: Epping - Hermann - Fischer

(56) Entgegenhaltungen:
- EP-A- 0 954 097
- KLEIN W ET AL: "TV-TUNER ATA" RADIO FERNSEHEN ELEKTRONIK,DE,VEB VERLAG TECHNIK. BERLIN, Bd. 44, Nr. 2, 1. Februar 1995 (1995-02-01), Seiten 26-27, XP000494292 ISSN: 1436-1574

## Beschreibung

Die Erfindung betrifft eine Schaltungsanordnung zur Filterung eines Hochfrequenzsignals mit einem frequenzsteuerbaren Oszillator und einem Filter mit einstellbarem Durchlaßbereich.

Filterschaltungen dieser Art werden beispielsweise in Tunern für Fernsehgeräte verwendet. Bekanntlich wird das Antennensignal mit einer Lokaloszillatorfrequenz gemischt und auf Zwischenfrequenz umgesetzt. Vor der Mischung ist eine Filterung erforderlich, um das Nutzsignalband aus dem breitbandigen Empfangssignal herauszufiltern. Die Charakteristik dieser gegebenenfalls mehrstufig aufgebauten Filterung wird dem Lokaloszillatorsignal und damit dem Empfangssignal nachgeführt. Filter, deren Durchlaßbereich mittels eines Steuersignals verschiebbar ist, sind als Tracking-Filter bekannt.

Die Filtercharakteristiken unterliegen jedoch herstellungsbedingten Schwankungen. Die Filterschaltung wird daher beim abschließenden Test abgeglichen. Hierzu werden aus einer Messung Korrekturwerte ermittelt, um die Mittenfrequenz der Filter nachzustimmen. Beispielsweise werden die Korrekturwerte in einem die Systemsteuerung abwickelnden Mikrocontroller dauerhaft gespeichert und nach geeigneter Digital-Analog-Wandlung dem Steuersignal für das Filter additiv überlagert. Diese Schaltungstechnik in Tunern wird als "Digital Alignment" bezeichnet.

Herkömmliche Tuner für Fernsehgeräte verarbeiten Abstimmspannungen bis in Höhe von 35 Volt. Zwar ist in modernen Halbleitertechnologien die Realisierung solcher Spannungsfestigkeiten prinzipiell möglich. Die Anforderungen an diese Halbleitertechnologie sind jedoch erheblich. Ebenso aufwendig sind die Anforderungen an die Schaltungstechnik, da Digital-Analog-Wandler und Addierer für die volle Spannungsfestigkeit von bis zu 35 Volt ausgelegt sein müssen. -

In der Literaturstelle W. Klein et al.: "TV-Tuner ATA", Radio Fernsehen Elektronik, VEB-Verlag Technik, Berlin, Band 44, Nr. 2, 1.2.1995, Seiten 26 bis 27 ist ein TV-Tuner gezeigt, der eine PLL mit drei D-A-Wandlern enthält, wobei die PLL eingangsseitig über einen I2C-Bus gesteuert wird und ausgangsseitig über jeweilige D-A-Wandler den Vorkreis und das Bandfilter steuert. Außerdem erzeugt die PLL eine Steuerspannung für einen spannungsgesteuerten Oszillator, der eine Oszillatorfrequenz für einen Mischer bereitstellt. Der Ausgangsspannungshub der D-A-Wandler ist schaltbar ausgebildet und kann für den unteren Frequenzbereich der Abstimmspannung und den oberen Frequenzbereich der Abstimmspannung unterschiedliche Spannungshübe bereitstellen.

Die Aufgabe der Erfindung besteht darin, eine Schaltungsanordnung zur Filterung eines Hochfrequenzsignals der eingangs genannten Art anzugeben, die bei entsprechender Güte der Filterung einen geringeren schaltungs- und halbleiterprozeßtechnischen Aufwand erfordert.

Gemäß der Erfindung wird diese Aufgabe gelöst durch eine Schaltungsanordnung zur Filterung eines Hochfrequenzsignals, umfassend: einen Anschluss zur Zuführung des Hochfrequenzsignals; einen Anschluss zur Zuführung eines Steuersignals; einen frequenzsteuerbaren Oszillator, dessen Schwingfrequenz in Abhängigkeit vom Steuersignal steuerbar ist; mindestens ein Filter mit einstellbarem Durchlassfrequenzbereich für ein Nutzsignal, wobei der Durchlassfrequenzbereich des Filters in Abhängigkeit vom Steuersignal steuerbar ist; dadurch gekennzeichet, daß das Filter eine Kapazitätsdiode enthält, die einen Anodenanschluss und einen Kathodenanschluss aufweist, wobei einer der Anoden- und Kathodenanschlüsse mit dem Anschluss zur Zuführung des Steuersignals gekoppelt ist; eine Einrichtung zur Bereitstellung eines Korrektursignals mit einem Anschluss zur Ausgabe des Korrektursignals vorhanden ist; und der Anschluss zur Ausgabe des Korrektursignals mit dem anderen der Anoden- und Kathodenanschlüsse der Kapazitätsdiode gekoppelt ist, um den Durchlassfrequenzbereich des Filters ebenfalls in Abhängigkeit vom Kor-rektursignal zu steuern.

Bei der Schaltungsanordnung gemäß der Erfindung greift das Korrektursignal an dem die Frequenzeinstellung des Filters bewirkenden Abstimmelement an und bewirkt eine Subtraktion zwischen Stellsignal und Korrektursignal. Das Korrektursignal wird gegenphasig dem verglichen mit dem Stellsignal anderen Pol des Abstimmelements des Filters zugeführt. Bei gleichem Dynamikbereich für das Korrektursignal ist der Absolutbereich für das Korrektursignal wesentlich geringer. Die zu verarbeitenden Korrektursignale sind auf den nur zur Korrektur benötigten Wertebereich beschränkt. Dies hat zufolge, dass die betroffenen Schaltungsteile wie beispielsweise Digital-Analog-Wandler nur für eine Spannungsfestigkeit im Wertebereich des Korrektursignals auszulegen sind, nicht aber mehr für einen Wertebereich der gesamten Abstimmspannung wie bisher. In vorteilhafter Weise wird dadurch erreicht, daß die Realisierung der Schaltung in modernen Halbleitertechnologien mit niedriger Spannungsfestigkeit erfolgen kann. Dadurch ergibt sich ein erheblicher Kostenvorteil für die Herstellung solcher Schaltungen und damit verbunden für die gesamte Filterschaltung.

Das frequenzveränderbare Element der Filterschaltung ist eine Kapazitätsdiode. Die variable Kapazität der Kapazitätsdiode wird durch die an ihr anliegende Spannung verändert. Das Stellsignal, welches auch dem frequenzveränderbaren Oszillator zugeführt wird, greift am Kathodenanschluß an. Das Korrektursignal wird am Anodenanschluß der Kapazitätsdiode angelegt. In Bezug auf die an der Kapazitätsdiode abfallende Spannung überlagern sich Stell- und Korrektursignal als Differenz. Dies hat zur Folge, daß das Korrektursignal im Absolutwert nur in dem für die Korrektur vorgesehenen Wertebereich bleiben kann.

Das Korrektursignal wird ebenso wie das Stellsignal als Analogsignal bereitgestellt. Das Korrektursignal wird am Ende der Herstellung der Filterschaltung durch Messung ermittelt. Zweckmäßigerweise erfolgt die dauerhafte Abspeicherung des Korrektursignals digital in einem nichtflüchtigen Speicher eines Mikrocontrollers. Es wird im Betrieb der Filterschaltung durch einen Digital-Analog-Wandler in das analoge Korrektursignal umgesetzt. Solche Mikrocontroller und geeignete Digital-Analog-Wandler sind hinreichend bekannt.

Insgesamt wird die Filterung von mehreren bezüglich ihres Nutzsignals hintereinander geschalteten einstellbaren Filtern, sogenannten Tracking-Filtern, ausgeführt. Das Eingangssignal, welches von einer Antenne nach geeigneter Anpassung bereitgestellt wird, wird einem ersten Bandpaß zugeführt, dessen Mittenfrequenz nachstellbar ist. Ausgangsseitig ist ein zweiter Bandpaß nachgeschaltet. Diesem wiederum folgt ein gekoppelter dritter Bandpaß, durch den auch die Spiegelfrequenzen unterdrückt werden. Der Durchlaß- bzw. Sperrbereich der Filter ist verschiebbar. Diese Verschiebung wird von einem Steuersignal bewirkt. Die drei Filter werden zweckmäßigerweise vom gleichen Steuersignal angesteuert. Das Steuersignal dient ebenfalls dazu, die Frequenz des Lokaloszillators für die Abwärtsmischung auf Zwischenfrequenz einzustellen. Jedem der Filter wird außerdem ein individuelles, aufgrund einer Abgleichsmessung ermitteltes Korrektursignal zugeführt.

Die Filter selbst umfassen jeweils einen Signalpfad mit in Reihe geschalteten Induktivitäten und Kapazitäten. Das frequenzveränderbare Element ist mit dem Anodenanschluß an diesen Signalpfad gekoppelt. Das Steuersignal sowie die Korrektursignale werden über jeweilige Widerstände zur Gleichstromentkopplung an Kathoden- bzw. Anodenanschlüsse der Kapazitätsdioden angelegt.

Die Filterschaltung dient dazu, das Nutzsignal aus dem antennenseitigen Empfangssignal abzutrennen, so daß anschließend mit dem dem eingestellten Empfangskanal entsprechenden Lokaloszillatorsignal die Abwärtsmischung auf Zwischenfrequenz ausgeführt wird. Das wesentliche Anwendungsgebiet der Schaltung liegt im Bereich von Tunern für Fernsehgeräte. Da dieses Marktsegment überaus kostensensitiv ist, wird durch die durch die Erfindung ermöglichten kostengünstigen Tunerschaltungen ein besonderer wirtschaftlicher Vorteil erreicht.

Nachfolgend wird die Erfindung anhand der in der Zeichnung dargestellten Figuren näher erläutert. Einander entsprechende Elemente und Signale sind mit gleichen Bezugszeichen versehen. Es zeigen:
- Figur 1: einen Ausschnitt aus einem Tuner für ein Fernsehgerät unter Anwendung der Filterschaltung gemäß der Erfindung,
- Figur 2: ein Detailschaltbild eines ersten Bandpasses zur Anwendung in der Filterschaltung gemäß der Erfindung, wobei nur wesentliche Elemente dargestellt sind und
- Figur 3: eine Detailschaltung eines zweiten Bandpasses sowie eines gekoppelten dritten Bandpasses zur Anwendung in der Filterschaltung gemäß der Erfindung, wobei wiederum nur wesentliche Elemente dargestellt sind.

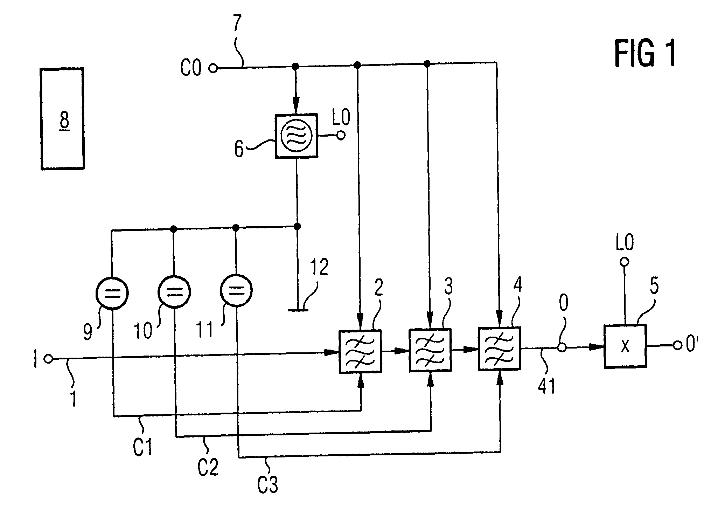

Die Filterschaltung in Figur 1 zeigt einen Eingangsanschluß 1, an dem ein von einer Antenne abgeleitetes Eingangssignal I eingespeist wird. Das Eingangssignal I wird in einem ersten Bandpaß 2, einem nachgeschalteten Bandpaß 3 sowie einem diesem nachgeschalteten gekoppelten Bandpaß 4 gefiltert. Zwischen die Bandpaßfilter 2 und 3 ist ein Verstärker geschaltet. Der gekoppelte Bandpaß 4 sorgt auch für eine Unterdrükkung von Spiegelfrequenzen. Das Ausgangssignal O am Ausgangsanschluß 41 der Bandsperre 4 wird einem Abwärtsmischer 5 zugeführt. Im Mischer 5 wird das Signal O mit einem Lokaloszillatorsignal LO gemischt, um ein Ausgangssignal O' in Zwischenfrequenzlage zu erhalten. Das Lokaloszillatorsignal LO wird von einem spannungssteuerbaren Oszillator (VCO) 6 bereitgestellt. Ein Steuersignal C0 an einem Anschluß 7 dient zur Frequenzeinstellung des VCO 6. Die gezeigte Schaltung ist Teil eines Tuners für Fernsehgeräte. Entsprechend dem gewünschten Empfangskanal wird durch das Steuersignal C0 der VCO 6 auf die geeignete Lokaloszillatorfrequenz eingestellt, so daß das Nutzsignal des Empfangskanals im Ausgangssignal O' bei Zwischenfrequenz vorliegt. Hierzu werden die Durchlaß- bzw. Sperrbereiche der Filter 2, 3 und 4 ebenfalls vom Steuersignal C0 gemeinsam angesteuert, um dem Mischer 5 das hochfrequenzseitige Empfangssignal des gewünschten Kanals selektiv bereitzustellen.

Die Herstellung der Filter 2, 3 und 4 als diskrete Schaltung unterliegt Fertigungstoleranzen. Zum Abgleich der Filter 2, 3, 4 wird am Ende des Fertigungsprozesses des Tuners mittels einer Messung ein Korrekturwert erzeugt, durch den die Filter fein abgestimmt werden. Der Korrekturwert ist in einem nichtflüchtigen Speicher eines Mikroprozessors 8 einprogrammiert. Der Mikroprozessor 8 steuert den Betrieb der Schaltung. Entsprechend dem relativ breiten Empfangsbereich für Fernsehsignale kann das Abstimmsignal C0 Signalpegel bis in Höhe von 35 Volt aufweisen. Die im Mikrocontroller 8 digital gespeicherten Korrekturwerte für die Filter 2, 3 und 4 werden durch den Filtern jeweils zugeordnete Digital-Analog-Wandler 9, 10 bzw. 11 in analoge Korrektursignale C1, C2 bzw. C3 umgesetzt. Die Digital-Analog-Wandler 9, 10 und 11 sind an Bezugspotential 12 angeschlossen, so daß die Signale C1, C2 und C3 auf Masse bezogen sind. Die Absolutpegel der Korrektursignale C1, C2 und C3 beschränken sich nur auf den zur Korrektur benötigten Wertebereich. Dieser Wertebereich schließt Massepotential 12 ein und liegt wesentlich niedriger als der Abstimmbereich für das Steuersignal C0, welcher bis zu 35 Volt reichen kann. Dieser geringe Wertebereich für die Korrektursignale C1, C2 und C3 wird dadurch ermöglicht, daß diese Korrektursignale gegenphasig zum Steuersignal C0 an das frequenzbestimmende Element in den Filtern 1, 2 und 3 angelegt wird. Dies bedeutet, daß der eine Anschluß des frequenzbestimmenden Elements wie herkömmlich mit dem Stellsignal C0 beaufschlagt wird, während das jeweilige Korrektursignal C1, C2 oder C3 an den anderen Anschluß des frequenzbestimmenden Elements angelegt wird. Dadurch ergibt sich eine Differenzbildung zwischen dem Stellsignal und dem Korrektursignal für die am frequenzbestimmenden Element abfallende Spannung, welche die Frequenzeinstellung bewirkt.

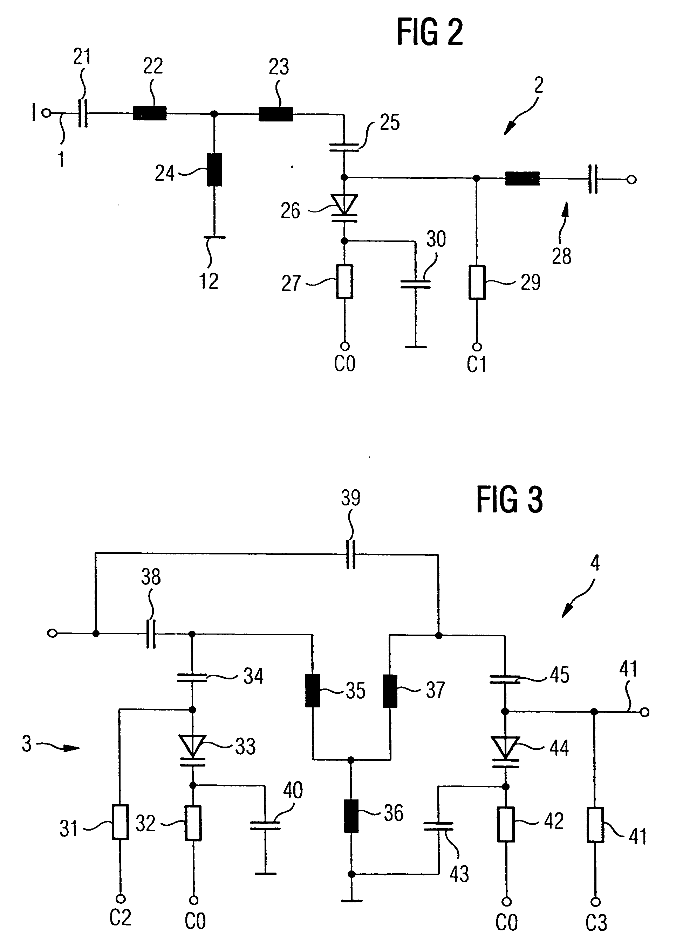

Die Beschaltung des frequenzbestimmenden Elements ist in Figur 2 für den Bandpaß 2 dargestellt. Das frequenzbestimmende Element ist eine Kapazitätsdiode. Der Signalpfad für das Nutzsignal I am Anschluß 1 umfaßt eine Koppelkapazität 21, der eine Sternschaltung aus Induktivitäten 22, 23 und 24 nachgeschaltet ist. Die beiden Induktivitäten 22 und 23 liegen in Reihe, während die Induktivität 24 nach Masse 12 geschaltet ist. Im Signalpfad folgt ein Koppelkondensator 25, an welchem die Kapazitätsdiode 26 als frequenzbestimmendes Element für das Bandpaßfilter 2 angeschlossen ist. Der Anodenanschluß der Kapazitätsdiode 26 ist an den Kondensator 25 gekoppelt. Am Kathodenanschluß der Kapazitätsdiode 26 wird das Stellsignal C0 über einen Widerstand 27 zur Wechselstromentkopplung zugeführt. Der Kathodenanschluß der Kapazitätsdiode 26 ist außerdem über eine Kapazität 30 nach Masse geschaltet. Am Anodenanschluß der Kapazitätsdiode 26 wird das Nutzsignal über die Reihenschaltung 28 aus einer Spule und einer weiteren Koppelkapazität aus dem Filter 2 ausgekoppelt. An den Anodenanschluß der Kapazitätsdiode 26 wird außerdem das Korrektursignal C1 über einen Entkopplungswiderstand 29 angelegt. Durch diese Beschaltung der Kapazitätsdiode 26 wirkt das Korrektursignal C1 bezüglich des Stellsignals C0 gegenphasig. Dies bedeutet, daß sich die an der Kapazitätsdiode 26 abfallende Spannung aus der Differenz der Signale C0 und C1 ergibt. Während das Stellsignal C0 in der Praxis bis zu 35 Volt betragen kann, genügt es, daß sich der Wertebereich des Signals C1 nur auf den für die Korrektur erforderlichen Bereich beschränkt. Dieser Wertebereich umfaßt und liegt in der Nähe von 0 Volt. Insgesamt ist durch die gezeigte Schaltung die Mittenfrequenz des Bandpaßfilters mittels des Signals C0 entsprechend der Frequenz des Lokaloszillatorsignals LO des VCOs 6 nachführbar. Durch das programmierte, feste Korrektursignal C1 wird eine Feinabstimmung zum Ausgleich von Fertigungstoleranzen bewirkt.

In Figur 3 sind das Bandpaßfilter 3 sowie das gekoppelte Bandpaßfilter 4 in Kombination dargestellt. Das vom Bandpaßfilter 2 ausgegebene Signal wird gegebenenfalls über einen Verstärker mit einem MOS-Feldeffekttransistor verstärkt und dann dem Eingang des Filters 3 zugeführt. Der Anodenanschluß der Kapazitätsdiode 33 des Bandpaßfilters 3 ist über einen ersten und einen zweiten Koppelkondensator 34, 38 an den Eingang des Filters 3 angeschlossen. Entsprechend zum Bandpaßfilter 2 wird auch im Bandpaßfilter 3 der Kathodenanschluß der Kapazitätsdiode 33 über einen Entkopplungswiderstand 32 mit dem Stellsignal C0 beaufschlagt. Der Kathodenanschluß der Kapazitätsdiode 33 ist außerdem über eine Kapazität 40 nach Masse geschaltet. An den Anodenanschluß der Kapazitätsdiode 33 wird über einen Entkopplungswiderstand 31 das Korrektursignal C2 angelegt. Über eine Sternschaltung aus drei Induktivitäten 35, 36 und 37 wird das Nutzsignal aus dem Bandpaßfilter 3 ausgekoppelt. Eine Kapazitätsdiode 44, die das frequenzveränderbare Element des Bandpaßfilters 4 bildet, ist über einen Kopplungskondensator 45 an die Induktivität 37 angeschlossen. Eine Sperre für die Spiegelfrequenz ergibt sich durch Kopplung der Bandpässe 4, 3 über eine Kapazität 39. Diese Kapazität 39 ist zwischen den Eingang des Filters 3 und den Knoten zwischen Induktivität 37 und Kapazität 45 geschaltet. Auch hier wird das Stellsignal C0 über einen Entkopplungswiderstand 42 an den Kathodenanschluß der Kapazitätsdiode 44 angelegt. Das Korrektursignal C3 wird über einen Entkopplungswiderstand 41 an den Anodenanschluß der Kapazitätsdiode 44 geführt. Das Ausgangssignal O ist über einen Anschluß 41 an der Anode der Kapazitätsdiode 44 abgreifbar. Der Kathodenanschluß der Kapazitätsdiode 44 ist über einen Kondensator 43 mit Masse verbunden. In Bezug auf das kathodenseitige Stellsignal C0 der Kapazitätsdioden 33 und 44 wirkt das jeweils zugeordnete Korrektursignal C2 bzw. C3 gegenphasig, da es am jeweiligen Anodenanschluß der Kapazitätsdioden 33 und 44 zugeführt wird. Die Korrektursignale C2 und C3 können daher bei niedrigem Signalpegel vorliegen, der weit unterhalb des für das Stellsignal C0 vorgesehenen maximalen Signalpegels von bis zu 35 Volt liegt.

Durch die Filterschaltung gemäß der Erfindung ist es möglich, daß die Schaltungsteile zur Bereitstellung der Korrektursignale C1, C2 und C3, insbesondere die Digital-Analog-Wandler 9, 10 und 11, in modernen Halbleiterprozeßtechnologien für niedrige Spannungsbereiche hergestellt werden können.

## Patentansprüche

1. Schaltungsanordnung zur Filterung eines Hochfrequenzsignals, umfassend:
- einen Anschluss (1) zur Zuführung des Hochfrequenzsignals (I) ;
- einen Anschluss (7) zur Zuführung eines Steuersignals (C0),
- einen frequenzsteuerbaren Oszillator (6), dessen Schwingfrequenz in Abhängigkeit vom Steuersignal (CO) steuerbar ist;
- mindestens ein Filter (2, 3, 4) mit einstellbarem Durchlassfrequenzbereich für ein Nutzsignal (I), wobei der Durchlassfrequenzbereich des Filters (2, 3, 4) in Abhängigkeit vom Steuersignal (CO) steuerbar ist;
**dadurch gekennzeichnet, dass**
- das Filter (2, 3, 4) eine Kapazitätsdiode (26, 33, 44) enthält, die einen Anodenanschluss und einen Kathodenanschluss aufweist, wobei einer der Anoden- und Kathodenanschlüsse mit dem Anschluss zur Zuführung des Steuersignals (C0) gekoppelt ist;
- eine Einrichtung (9, 10, 11) zur Bereitstellung eines Korrektursignals (C1, C2, C3) mit einem Anschluss zur Ausgabe des Korrektursignals (C1, C2, C3) vorhanden ist; und
- der Anschluss zur Ausgabe des Korrektursignals mit dem anderen der Anoden- und Kathodenanschlüsse der Kapazitätsdiode (26, 33, 34) gekoppelt ist, um den Durchlassfrequenzbereich des Filters ebenfalls in Abhängigkeit vom Korrektursignal (C1, C2, C3) zu steuern.

2. Schaltungsanordnung nach Anspruch 1,
**dadurch gekennzeichnet, dass**
der kathodenanschluss der Kapazitätsdiode (26, 33, 34) mit dem Anschluss zur Zuführung des Steuersignals (C0) gekoppelt ist und dass der Anodenanschluss mit dem Anschluss zur Ausgabe des Korrektursignals (C1, C2, C3) gekoppelt ist.

3. Schaltungsanordnung nach Anspruch 1 oder 2,
**dadurch gekennzeichnet, dass**
die Einrichtung zur Bereitstellung des Korrektursignals ein Digital-Analog-Umsetzer (9, 10, 11) ist, dessen Ausgangsanschluss den Anschluss zur Bereitstellung des Korrektursignals bildet.

4. Schaltungsanordnung nach einem der Ansprüche 1 bis 3,
**gekennzeichnet durch**
mindestens zwei weitere Filter (3, 4) mit einstellbarem Durchlassfrequenzbereich, wobei die Filter (2, 3, 4) bezüglich ihres Nutzsignalpfads in Reihe geschaltet sind, von denen ein erstes (2) und ein nachgeschaltetes zweites Filter (3) Bandpassfilter sind mit verschiedenem Durchlassfrequenzbereich und von denen ein drittes Filter (4) ein gekoppeltes Bandpassfilter mit einer Sperre für eine Spiegelfrequenz des Nutzsignals ist.

5. Schaltungsanordnung nach einem der Ansprüche 1 bis 4,
**dadurch gekennzeichnet, dass**
das Filter (2, 3, 4) mit einstellbarem Durchlassfrequenzbereich einen Signalpfad für das Nutzsignal umfasst, der mindestens ein kapazitives und ein induktives Element (21, 22, 23, 28; 38, 35, 37, 45) enthält, und dass der Anodenanschluss der Kapazitätsdiode (26, 33, 44) an den Signalpfad gekoppelt ist.

6. Schaltungsanordnung nach Anspruch 5,
**dadurch gekennzeichnet, dass**
der Anschluss zur Zuführung des Steuersignals (C0) und der Anschluss zur Ausgabe des Korrektursignals (C1, C2, C3) über jeweilige Widerstände (27, 29, 31, 32, 41, 42) von der Kapazitätsdiode (26, 33, 44) entkoppelt sind.

7. Schaltungsanordnung nach einem der Ansprüche 1 bis 6,
**dadurch gekennzeichnet, dass**
ein Nutzsignaleingang des einstellbaren Filters (2) mit einem Anschluss (1) für eine Antenne gekoppelt ist, an dem ein zu filterndes Hochfrequenzsignal empfangbar ist.

8. Schaltungsanordnung nach Anspruch 7,
**gekennzeichnet durch**
einen Mischer (5), der mit einem Ausgang des frequenzsteuerbaren Oszillators (6) sowie mit einem Nutzsignalausgang (41) des Filters (4) gekoppelt ist.

## Claims

1. Circuit arrangement for filtering a radiofrequency signal, comprising:
- a connection (1) for supplying the radiofrequency signal (I);
- a connection (7) for supplying a control signal (CO);
- a controllable-frequency oscillator (6) whose oscillating frequency can be controlled on the basis of the control signal (CO);
- at least one filter (2, 3, 4) having an adjustable frequency passband for a useful signal (I), where the frequency passband of the filter (2, 3, 4) can be controlled on the basis of the control signal (C0) ;
**characterized in that**
- the filter (2, 3, 4) contains a capacitance diode (26, 33, 44) which has an anode connection and a cathode connection, one of the anode and cathode connections being coupled to the connection for supplying the control signal (CO);
- a device (9, 10, 11) for providing a correction signal (C1, C2, C3) having a connection for outputting the correction signal (C1, C2, C3) is present; and
- the connection for outputting the correction signal is coupled to the other of the anode and cathode connections of the capacitance diode (26, 33, 34) in order to control the frequency passband of the filter likewise on the basis of the correction signal (C1, C2, C3).

2. Circuit arrangement according to Claim 1,
**characterized in that**
the cathode connection of the capacitance diode (26, 33, 34) is coupled to the connection for supplying the control signal (CO), and **in that** the anode connection is coupled to the connection for outputting the correction signal (C1, C2, C3).

3. Circuit arrangement according to Claim 1 or 2,
**characterized in that**
the device for providing the correction signal is a digital/analogue converter (9, 10, 11) whose output connection forms the connection for providing the correction signal.

4. Circuit arrangement according to one of Claims 1 to 3,
**characterized by**
at least two further filters (3, 4) having an adjustable frequency passband, the useful signal paths of the filters (2, 3, 4) being connected in series, and, of the filters, a first filter (2) and a downstream-connected second filter (3) are bandpass filters having different frequency passbands, and a third filter (4) is a coupled bandpass filter with a block for an image frequency of the useful signal.

5. Circuit arrangement according to one of Claims 1 to 4,
**characterized in that**
the filter (2, 3, 4) having an adjustable frequency passband comprises a signal path for the useful signal, which signal path contains at least one capacitive element and an inductive element (21, 22, 23, 28; 38, 35, 37, 45), and **in that** the anode connection of the capacitance diode (26, 33, 44) is coupled to the signal path.

6. Circuit arrangement according to Claim 5,
**characterized in that**
the connection for supplying the control signal (C0) and the connection for outputting the correction signal (C1, C2, C3) are decoupled from the capacitance diode (26, 33, 44) by means of respective resistors (27, 29, 31, 32, 41, 42).

7. Circuit arrangement according to one of Claims 1 to 6,
**characterized in that**
a useful signal input of the adjustable filter (2) is coupled to a connection (1) for an antenna, at which connection a radiofrequency signal which is to be filtered can be received.

8. Circuit arrangement according to Claim 7,
**characterized by**
a mixer (5) which is coupled to an output of the controllable-frequency oscillator (6) and also to a useful signal output (41) of the filter (4).

## Revendications

1. Circuit de filtrage d'un signal de haute fréquence comprenant
- une borne (1) d'entrée du signal (I) de haute fréquence,
- une borne (7) d'entrée d'un signal (CO) de commande,
- un oscillateur (6) pouvant être commandé par la fréquence et dont la fréquence d'oscillation peut être commandée en fonction du signal (CO) de commande,
- au moins un filtre (2, 3, 4) à bande de fréquence de transmission réglable pour un signal (I) utile, la bande de fréquence de transmission du filtre (2, 3, 4) pouvant être commandée en fonction du signal (CO) de commande,
**caractérisé en ce que**
- le filtre (2, 3, 4) comporte une diode (26, 33, 44) de capacité qui a une borne d'anode et une borne de cathode, l'une des bornes d'anode et de cathode étant couplée à la borne d'entrée du signal (CO) de commande,
- il y a un dispositif (9, 10, 11) de mise à disposition d'un signal (C1, C2, C3) de correction ayant une borne de sortie du signal (C1, C2, C3) de correction ; et
- la borne de sortie du signal de correction est couplée à l'autre des bornes d'anode et de cathode de la diode (26, 33, 34) de capacité pour commander la bande de fréquence de transmission du filtre également en fonction du signal (C1, C2, C3) de correction.

2. Circuit suivant la revendication 1,
**caractérisé en ce que**
la borne de cathode de la diode (26, 33, 34) de capacité est couplée à la borne d'entrée du signal (CO) de commande et **en ce que** la borne d'anode est couplée à la borne de sortie du signal (C1, C2, C3) de correction.

3. Circuit suivant la revendication 1 ou 2,
**caractérisé en ce que**
le dispositif de mise à disposition du signal de correction est un convertisseur (9, 10, 11) numérique-analogique dont la borne de sortie forme la borne de mise à disposition du signal de correction.

4. Circuit suivant l'une des revendications 1 à 3,
**caractérisé par**
au moins deux autres filtres (3, 4) à bande de fréquence de transmission réglable, les filtres (2, 3, 4) étant pour ce qui concerne leur trajet pour le signal utile montés en série, un premier (2) d'entre eux et un deuxième filtre (3) en aval étant des filtres passe-bande ayant des bandes de fréquence de transmission différentes et un troisième filtre (4) d'entre eux étant un filtre passe-bande couplé ayant un blocage de la fréquence miroir du signal utile.

5. Circuit suivant l'une des revendications 1 à 4,
**caractérisé en ce que**
le filtre (2, 3, 4) à bande de fréquence de transmission réglable comprend un trajet pour le signal utile qui comporte au moins un élément (21, 22, 23, 28, 38, 35, 37, 45) capacitif et un élément (21, 22, 23, 28, 38, 35, 37, 45) inductif, et **en ce que** la borne d'anode de la diode (26, 33, 44) de capacité est couplée au trajet du signal.

6. Circuit suivant la revendication 5,
**caractérisé en ce que**
la borne d'entrée du signal (CO) de commande et la borne de sortie des signaux (C1, C2, C3) de correction sont découplées de la diode (26, 33, 44) de capacité par des résistances (27, 29, 31, 32, 41, 42) respectives.

7. Circuit suivant l'une des revendications 1 à 6,
**caractérisé en ce que**
une entrée pour le signal utile du filtre (2) réglable est couplée à une borne (1) pour une antenne, sur laquelle peut être reçu un signal de haute fréquence à filtrer.

8. Circuit suivant la revendication 7,
**caractérisé par**
un mélangeur (5) qui est couplé à une sortie de l'oscillateur (6) pouvant être commandé par la fréquence, ainsi qu'à une sortie (41) pour le signal utile du filtre (4).
